# EUROPEAN PATENT APPLICATION

(11) **EP 1 312 960 A1**
(43) Date of publication of application: **21.05.2003**
(21) Application number: 02025425.6
(22) Date of filing: 14.11.2002
(51) Int. Cl.: G02B 6/42, H04B 10/04, H04B 10/06, H04B 10/12

(54) **Optical transmitting/receiving module and optical transmitting/receiving device comprising the same**

(30) Priority: 19.11.2001 JP 2001353717
(71) Applicant: MATSUSHITA ELECTRIC INDUSTRIAL CO., LTD, Kadoma-shi, Osaka 571-0000 (JP)
(72) Inventor: Tohgoh, Hitomaro, Yokohama-shi, Kanagawa 226-0014 (JP); Asano, Hiroaki, Yokohama-shi, Kanagawa 226-0002 (JP); Uchiyama, Hiroo, Yokohama-shi, Kanagawa 240-0024 (JP); Kobayashi, Masaki, Yokohama-shi, Kanagawa 226-0022 (JP); Negishi, Hidehiko, Machida-shi, Tokyo 195-0051 (JP); Ito, Masami, Moriguchi-shi, Osaka 570-0096 (JP); Kuwabara, Masahiro, Moriguchi-shi, Osaka 570-0032 (JP)
(74) Representative: Casalonga, Axel

(57) **Abstract**

The present invention provides a one-core bidirectional optical transmitting/receiving module for wavelength multiplexing, which does not require optical waveguide fabricated with high precision and which has superb high frequency characteristics and has very low optical and electrical crosstalks and available at low cost. At the middle of an optical fiber 1 buried in a glass substrate 3, a light irradiating portion is provided, which has a wavelength selection filter 2 placed obliquely to the optical fiber. The light irradiating portion is fixed immediately above a backside entrance type photodetection element 4 mounted on a ceramic substrate 6 by flip-clip bonding, and only optical signals with specific wavelength are received. An optical fiber extra portion 7 between a photodetection unit and a light emitting unit has sufficient length, and an end of the optical fiber is optically coupled with the light emitting element. Designed in simplified structure and requiring no optical waveguide, the optical transmitting/receiving module of the invention gives very low optical and electrical crosstalks and provides superb high frequency characteristics.

## Description

### BACKGROUND OF THE INVENTION

### Field of the Invention

The present invention relates to an optical transmitting/receiving module used for applications such as optical fiber communication, and the invention also relates to an optical transmitting/receiving device using the same.

### Description of the Related Art

Instead of metallic cable, attention is now focused on the communication using optical fiber, which can transmit large-capacity information at high speed and with low loss. With the propagation of optical devices available at low cost and operated at high speed, there are now strong demands on the devices with higher functions. As an example, efforts are now being made on the development of an optical communication system, which can provide communication by optical bidirectional transmission using a single optical fiber. For the optical module of this type, a technique is required, which can integrate a light emitting element, a photodetection element, and components for wavelength division and multiplexing.

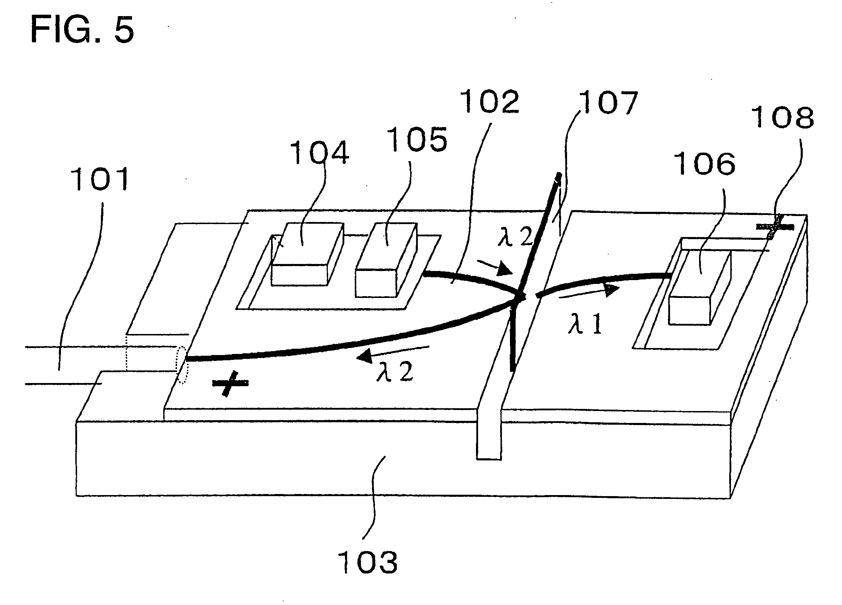

Description will be given below on a typical conventional example of optical bidirectional module. In the past, it has been generally practiced to use a structure, which combines an optical waveguide with a WDM filter for the purpose of separating a signal with receiving wavelength of λ 1 from transmitting wavelength of λ 2. Fig. 5 shows a conventional structure of a WDM (wavelength division multiplexing) optical bidirectional module using optical waveguide as described in JP-A-11-68705. A light emitting element 105, a monitor PD 104, and a photodetection element 106 are mounted on an end of an optical waveguide 102 formed on a Si substrate 103 after high-precision 2-dimensional adjustment so that incident and exit light beams can be optically coupled with the optical waveguide. For positional adjustment of the light emitting element and the photodetection element, passive alignment technique is adopted, by which the adjustment is performed by using an alignment marker 108 provided on the Si substrate in advance with high precision. An output light with wavelength of λ 2 of the light emitting element is reflected by a WDM filter 107 and is guided toward an optical fiber via the optical waveguide. In this case, core of the optical fiber is optically coupled with the optical waveguide. As an arrangement procedure generally performed, a V-groove is fabricated with high precision on the Si substrate 103 with respect to the position of the optical waveguide, and the optical fiber is fixed along the V-groove. On the other hand, an optical signal with wavelength of λ 1 transmitted from the optical fiber passes through the WDM filter 107 and is received by the photodetection element. The photodetection element is designed in such manner that a light entering from lateral direction of the chip can be received and detected.

The conventional example as described above has the problems as given below. In the conventional example, high precision in the order of submicron is required for the V-groove or for the mounting of the elements on the Si substrate. This means that expensive production facilities are needed, and variation or deviation in the accuracy leads to deterioration of production yield. Also, complicated processes are required for providing the optical waveguide with high precision. Further, it is difficult to obtain the Si substrate at low cost because the Si substrate with optical waveguide is relatively large in size. Also, the photodetection element and the light emitting element are mounted in the same package, and this leads to the problem of high optical and electrical crosstalks. In particular, in high-speed communication, the influence from the deterioration due to electrical crosstalk increases, and the light emitting element must be separated from the photodetection element by a certain distance. In the conventional example, the substrate for optical waveguide or package must be designed larger in size, and this causes the difficulty to produce it at low cost.

To solve the above problems, it is an object of the present invention to provide an optical transmitting/ receiver module and an optical transmitting device, which requires no optical waveguide, gives lower optical and electrical crosstalks and does not need expensive production facilities and can be produced at low cost.

Next, description will be given on the means for solving the above problems.

The optical transmitting/receiving module according to an aspect of the present invention is characterized in that a cut-off surface is formed at the middle of the optical fiber so that the cut-off surface obliquely crosses the core of the optical fiber, a filter or a half-mirror is sandwiched between cores of the two optical fibers on each side of the cut-off surface, and an oblique light irradiating portion is formed, there are provided a first optical system and a second optical system, the first optical system has one of either a photodetection element or a light emitting element optically coupled to the oblique light irradiating portion, and the second optical system has the other of the photodetection element or the light emitting element optically coupled with an end of the optical fiber.

With the arrangement as described above, it is possible to provide an optical transmitting/receiving module for wavelength multiplexing by using a simplified optical system and without requiring optical waveguide.

A modification of the present invention provides the optical transmission/receiving module as described above, wherein the optical fiber connecting the first optical system with the second optical system has sufficient length and is fixed with a certain curvature so that characteristics of the optical fiber may not be deteriorated.

By this arrangement, the influence from tensile force and other unfavorable conditions can be eliminated when the optical fiber is fixed, and the first optical system can be separated from the second optical system. This makes it possible to reduce optical and electrical crosstalks. Also, there is no need to adjust the length of the optical fiber connecting the first optical system with the second optical system.

Another modification of the present invention provides the optical transmitting/receiving module as described above, wherein said first optical system, said second optical system, and said optical fiber are mounted in approximately linear arrangement.

By this arrangement, the area occupied by extra portion of the optical fiber between the first optical system and the second optical system can be decreased. Also, it is possible to integrate a plurality of the optical transmitting/receiving modules, which comprise the first and the second optical systems where the optical fiber for connecting the first optical system with the second optical system is arranged approximately in linear direction.

Another modification of the present invention provides the optical transmitting/receiving module as described above, wherein an element to be coupled with the first optical system is a photodetection element, and an element to be coupled with the second optical system is a light emitting element.

By this arrangement, the light emitting element can be optically coupled with an end surface of the optical fiber of the second optical system, and this contributes to the improvement of optical coupling efficiency. On the other hand, compared with diameter of exit light beam from the light emitting element, diameter of the light beam received by the photodetection element is larger, being several tens of microns. Thus, even when an optical system on the oblique light irradiating portion such as the first optical system has no lens, optical coupling efficiency of the photodetection element is not decreased.

Another modification of the present invention provides the optical transmitting/receiving module as described above, wherein said photodetection element is designed as a backside entrance type structure where light enters from a side opposite to an electrode side with PN electrode, and said photodetection element is mounted on a first circuit substrate by flip-chip bonding.

By this arrangement, no lens is required in the optical system of the photodetection element and the structure can be simplified. Also, no bonding wire is required, and this contributes to the improvement of high frequency characteristics of the optical receiving circuit. Because the photodetection element is coated with a material such as sealing resin, there is no influence from humidity, and no package is required.

Another modification of the present invention provides the optical transmitting/receiving module as described above, wherein a ground line and a signal line on a first circuit substrate are connected to a pattern on lower surface of the first circuit substrate via a via hole, and the ceramic substrate is mounted on a second circuit substrate by soldering.

By this arrangement, no bonding wire is required, and wiring with the circuit substrate can be provided. This contributes to the improvement of high frequency characteristics of the optical receiving unit.

Another modification of the present invention provides the optical transmitting/receiving module as described above, wherein said second optical system optically coupled with the light emitting element mounted in a can package is a coaxial type optical system, and said can package is mounted on a recessed portion on a part of the second circuit substrate.

By this arrangement, the optical fiber connecting the first optical system with the second optical system can be positioned immediately above the second circuit substrate. There is no need to have the optical fiber with a length longer than actually required, and compact design can be achieved. Also, the lead wires for the can package of the second optical system can be shortened, and this contributes to the improvement of high frequency characteristics of the optical transmitting circuit.

### BRIEF DESCRIPTION OF THE DRAWINGS

Fig. 1 is a perspective view schematically showing an arrangement of a first embodiment of an optical transmitting/receiving module of the present invention;
Fig. 2 is a cross-sectional view of a portion near an optical receiver of the first embodiment of the present invention;
Fig. 3 is a perspective view showing an optical transmitting device using the first embodiment of the present invention;
Fig. 4A is a plan view of a second embodiment of the optical transmitting/receiving module of the present invention;
Fig. 4B is a side view of the second embodiment of the optical transmitting/receiving module of the present invention; and
Fig. 5 is a perspective view schematically showing arrangement of a conventional type optical transmitting/ receiving module.

### DETAILED DESCRIPTION OF ILLUSTRATIVE EMBODIMENTS

Description will be given below on embodiments of the present invention referring to the drawings.

### (First embodiment )

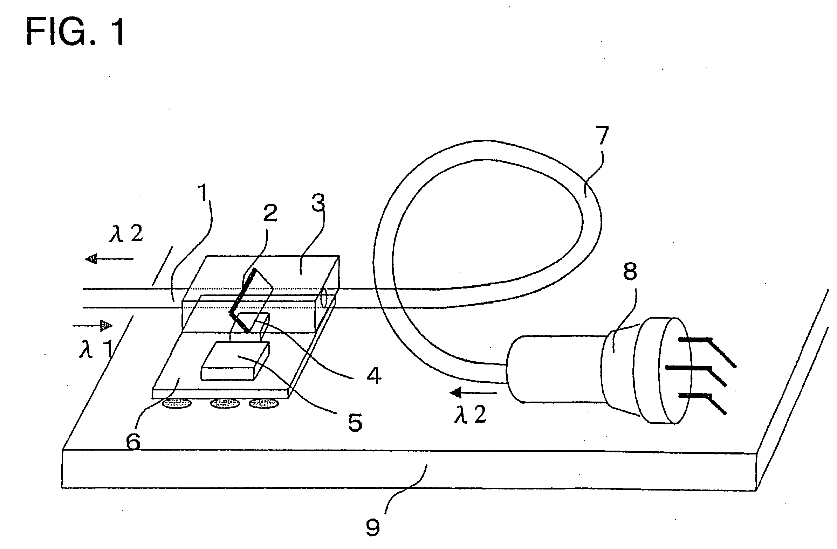

Fig. 1 is a perspective view of an optical transmitting/receiving module in a first embodiment of the present invention. On a control circuit resin substrate 9 serving as a substrate of a module, a ceramic substrate 6 provided with a photodetection element 4 and a preamplifier 5 is mounted. On the photodetection element 4, an in-line type optical system is fixed, which contains a wavelength selection filter 2 disposed at the middle of an optical fiber 1. A light emitting element is optically coupled with an end of the optical fiber at a position somewhat separated from the in-line type optical system of the photodetection unit, and it is mounted on the control circuit resin substrate 9. Optical axis adjusting process for the light emitting element is performed independently from optical axis adjusting process for the photodetection element. In the present embodiment, a light emitting element mounted in a TO can package to make up a light emitting element module 8 is used, and this is optically coupled with the optical fiber 1 by active alignment, while an optical system using passive alignment may be used.

All of the receiving light beams with wavelength of λ 1 enter the photodetection element 4 via an in-line type optical system (to be described later). On the other hand, transmitting light beams with wavelength of λ 2 pass through the in-line type optical system and are transmitted in a direction opposite to the receiving light beams.

In the past, an optical receiving unit and an optical transmitting unit have been integrated in the same package, and it was difficult to reduce electrical crosstalk. In the present embodiment, the optical receiving unit is connected with the optical transmitting unit via an optical fiber extra portion 7, and distance between these two units can be set freely. Thus, it is possible to minimize electrical crosstalk of the optical receiving unit and the optical transmitting unit.

Also, a transmission light from the light emitting element passes only the core of the optical fiber 1. Accordingly, compared with the conventional case, stray light does not enter the photodetection element, and optical crosstalk can be minimized.

Also, an extra portion with sufficient length of the optical fiber 1 is provided between the optical receiving unit and the optical transmitting unit. As a result, there is no need to control the length of the optical fiber extra portion 7, and no tensile stress is applied on the optical fiber 1. However, bending radius of the optical fiber 1 must be controlled to such a length that no optical loss occurs.

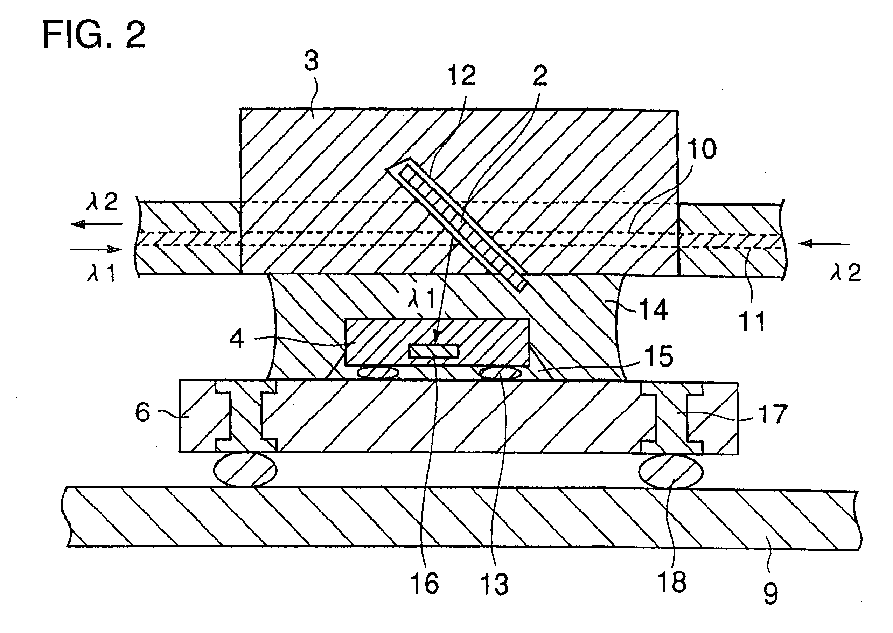

Next, description will be given on a method for packaging the photodetection element and also on detailed structure of the in-line type optical system. Fig. 2 is a cross-sectional view of the first embodiment near the optical receiving unit. A rear entrance type photodetection element 4 is mounted by flip-chip bonding on a ceramic substrate 6. At the same time, a preamplifier 5 is also mounted on the same ceramic substrate 6 by flip-chip bonding. As a result, distance from the photodetection element can be reduced, and this provides satisfactory high frequency characteristics. Also, the photodetection element 4 and the preamplifier 5 are covered with a sealing resin 15 for flip-chip bonding. This prevents the influence of humidity and other unfavorable causes, and there is no need to provide a package to enclose the entire photodetection element.

The ceramic substrate 6 is mounted by soldering it on the control circuit resin substrate 9 commonly used for the optical receiving unit and the optical transmitting unit. A pattern on the ceramic substrate 6 is electrically connected to a backside pad via a via hole 17, and this can be mounted on the control circuit resin substrate 9 by soldering method similar to the procedure used for chip size package (CSP).

After the optical fiber 1 is buried in a groove 10 formed on a glass substrate 3 and is fixed, a slit 12 is formed by using a dicing saw so that it obliquely crosses an optical fiber core 11. Then, a wavelength selection filter 2 is placed and fixed. The wavelength selection filter 2 reflects only a receiving light with wavelength λ 1 transmitted via the optical fiber. The glass substrate 2 is adjusted to an adequate position so that the reflection light reaches a photodetection unit 16 of the photodetection element. Then, it is fixed immediately above the photodetection element 4 by using a UV-setting resin 14. Adjustment should be made so that optical current of the photodetection element reaches the maximum. Because the wavelength selection filter 2 and the photodetection unit 16 are arranged closer to each other, high optical coupling efficiency can be attained without using lens. By providing AR coating on upper surface of the photodetection element 4, light reflection loss can be reduced. By the arrangement as described above, it is possible to pick up only the receiving light with wavelength λ 1 and to obtain a simplified in-line type optical system, which can be optically coupled to the photodetection element.

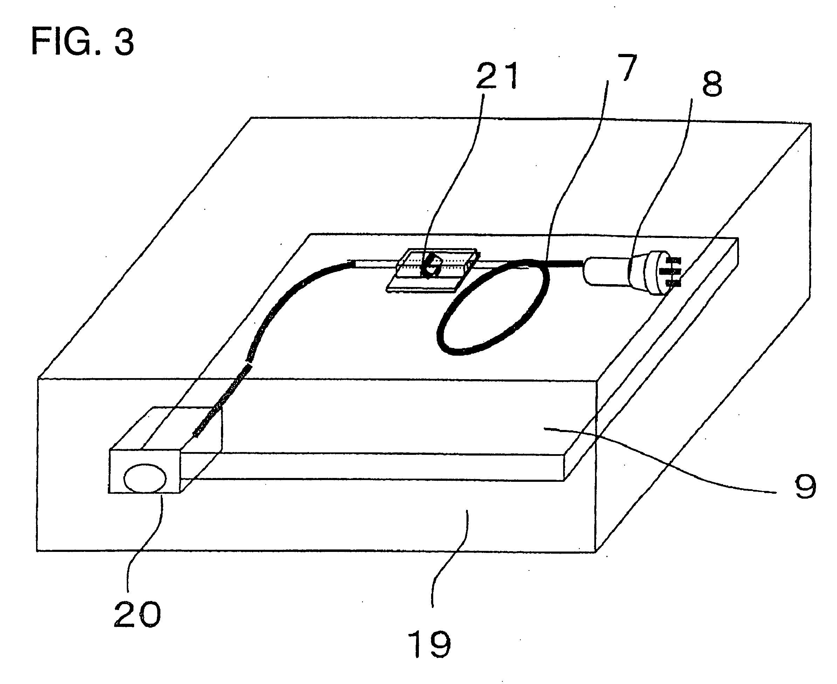

Fig. 3 is a perspective view of an optical transmitting/receiving device, which has a function to transmit and receive one-core bidirectional optical signal for wavelength multiplexing and uses the optical transmitting/receiving module of the first embodiment of the present invention. The optical receiving unit and a light emitting element module 8 are mounted on the control circuit resin substrate 9, which also serves as a main resin substrate of the optical transmitting device, and it is accommodated in a housing 19 for the optical transmitting device. On a front panel of the housing 19, an optical fiber connector plug 20 having function of an optical input/output port is mounted. The control circuit function substrate of the optical module shown in Fig. 1 is commonly used for the main resin substrate of the optical transmitting device, and this makes it possible to reduce the number of the components in use.

### (Second embodiment)

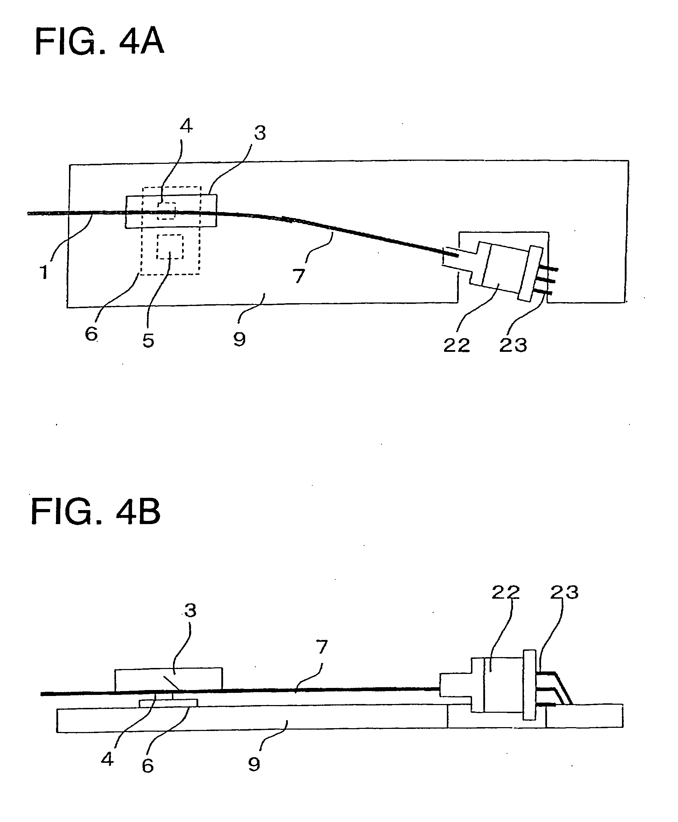

Figs. 4A and 4B represent an arrangement of the optical transmitting/receiving module in the second embodiment of the present invention. Fig. 4A is a plan view, and Fig. 4B is a side view. Basic arrangement including a photodetection element, an in-line optical system, and a light emitting element is the same as in the first embodiment, and description is given here only on the difference. The difference of the second embodiment from the first embodiment is that the optical fiber between the photodetection unit and the light emitting unit is running approximately in linear direction and that a notch or a recess is formed on a resin substrate where the light emitting unit is mounted.

If an optical fiber extra portion 7 with sufficient length is provided as in the first embodiment, the distance between the optical receiving unit and the optical transmitting unit can be freely set, but a space to accommodate the optical fiber extra portion must be designed larger. In this respect, in the second embodiment, the optical fiber extra portion is designed in linear form with a certain curvature. In so doing, the influence from tensile force caused by the difference of thermal expansion coefficient between the resin substrate and the optical fiber and applied on the optical fiber can be eliminated. Also, no additional space is needed for the optical fiber extra portion, and the resin substrate can be designed in an elongated shape. This facilitates the designing of the optical transmitting/receiving unit with multiple ports.

When a TO can package 22 is used as the light emitting element, a recess or a bore is formed on a part of the resin substrate as shown in Figs. 4A and 4B. As a result, the lead wires 23 of the TO can package can be designed shorter in length, and this contributes to the improvement of high frequency characteristics. The optical fibers can be aligned in height between the optical receiving unit and the optical transmitting unit. As a result, the length of the optical fiber can be shortened.

As described above, according to the present invention, a core of the optical fiber is cut so that it obliquely crosses at the middle of the optical fiber. Between the cores of the two optical fibers thus cut off, a filter or a half-mirror is sandwiched, and an oblique light irradiating portion is formed. There are provided a first optical system and a second optical system. In the first optical system, one of either the photodetection element or the light emitting element is optically coupled to the light irradiating portion. In the second optical system, the other of the photodetection element or the light emitting element is optically coupled to an end of the optical fiber. As a result, an optical transmitting/receiving module for wavelength multiplexing can be provided by using a simplified optical system without requiring the use of expensive optical waveguide.

Also, according to the present invention, the optical fiber for connecting the first optical system with the second optical system is fixed as it is bent to prevent the influence of tensile force when it is fixed. As a result, the influence from tensile force can be eliminated when the optical fiber is fixed. Also, the first optical system and the second optical system can be separated from each other by a certain distance. This contributes to the reduction of optical and electrical crosstalks.

Further, according to the present invention, the first optical system, the second optical system, and the optical fiber are aligned in approximately linear direction. This makes it possible to reduce the area to be occupied by the optical fiber extra portion between the first optical system and the second optical system. Also, the system can be easily integrated by aligning a plurality of optical transmitting/receiving modules, each of which comprises the first and the second optical systems.

Also, according to the present invention, an element to be coupled with the first optical system is designed as a photodetection element, and an element to be coupled with the second optical system is designed as a light emitting element. As a result, the light emitting element can be optically coupled with an end surface of the optical fiber of the second optical system. This contributes to the increase of optical coupling efficiency.

Further, according to the present invention, the photodetection element is designed as a backside entrance type structure where light enters from a side opposite to an electrode side with PN electrode. The photodetection element is mounted on the first circuit substrate by flip-chip bonding. Thus, there is no need to use any lens in the optical system of the photodetection element and also no need to use bonding wire. This contributes to the improvement of high frequency characteristics of the optical receiving circuit.

In addition to the above arrangement, a ground line and a signal line on the first circuit substrate are connected to a pattern on lower surface of the first circuit substrate via a via hole. Further, the ceramic substrate is mounted on the second circuit substrate by soldering. Thus, no bonding wire is required, and wiring with the circuit substrate can be provided. This contributes to the improvement of high frequency characteristics of the optical receiving unit.

In addition to the above arrangement, the second optical system to be optically coupled with the light emitting element mounted in the TO can package is designed as a coaxial optical system. The TO can package is mounted on a recessed portion formed on a part of the second circuit substrate. As a result, the optical fiber connecting the first optical system with the second optical system can be placed immediately above the second circuit substrate. Thus, there is no need to have longer optical fiber than actually required and it can be designed in compact size. Also, the length of the lead wire of the TO can package of the second optical system can be shortened, and this contributes to the improvement of high frequency characteristics of the optical transmitting circuit.

## Claims

1. An optical transmitting/receiving module, having an optical fiber, a photodetection element and a light emitting element coupled with each other, said module is **characterized in that** a cut-off surface is formed at the middle of the optical fiber so that the cut-off surface obliquely crosses the core of the optical fiber, a filter or a half-mirror is sandwiched between cores of the two optical fibers on each side of the cut-off surface, and an oblique light irradiating portion is formed, there are provided a first optical system and a second optical system, the first optical system has one of either of said photodetection element or said light emitting element optically coupled to the oblique light irradiating portion, and the second optical system has the other of the photodetection element or the light emitting element optically coupled with an end of the optical fiber.

2. The optical transmitting/receiving module according to claim 1, wherein the optical fiber connecting the first optical system with the second optical system is fixed with a certain curvature so that characteristics of the optical fiber may not be deteriorated.

3. The optical transmitting/receiving module according to claim 2, wherein said first optical system, said second optical system, and said optical fiber are mounted in approximately linear arrangement.

4. The optical transmitting/receiving module according to claim 2, wherein an element to be coupled with the first optical system is a photodetection element, and an element to be coupled with the second optical system is a light emitting element.

5. The optical transmitting/receiving module according to claim 4, wherein said photodetection element is designed as a backside entrance type structure where light enters from a side opposite to an electrode said with PN electrode, and said photodetection element is mounted on a first circuit substrate by flip-chip bonding.

6. The optical transmitting/receiving module according to claim 5, wherein a ground line and a signal line on a first circuit substrate are connected to a pattern on lower surface of the first circuit substrate via a via hole, and the ceramic substrate is mounted on a second circuit substrate by soldering.

7. The optical transmitting/receiving module according to claim 6, wherein said second optical system optically coupled with the light emitting element mounted in a can package is a coaxial type optical system, and said can package is mounted on a recessed portion on a part of the second circuit substrate.

8. An optical transmitting/receiving device, **characterized in that** the device is provided with an optical transmitting/receiving module, having an optical fiber, a photodetection element and a light emitting element coupled with each other, said module being arranged such that a cut-off surface is formed at the middle of the optical fiber so that the cut-off surface obliquely crosses the core of the optical fiber, a filter or a half-mirror is sandwiched between cores of the two optical fibers on each side of the cut-off surface, and an oblique light irradiating portion is formed, there are provided a first optical system and a second optical system, the first optical system has one of either of said photodetection element or said light emitting element optically coupled to the oblique light irradiating portion, and the second optical system has the other of the photodetection element or the light emitting element optically coupled with an end of the optical fiber.
